# EUROPÄISCHE PATENTANMELDUNG

(11) **EP 1 816 481 A1**
(43) Veröffentlichungstag der Anmeldung: **08.08.2007**
(21) Anmeldenummer: 07000487.4
(22) Anmeldetag: 11.01.2007
(51) Int. Cl.: G01R 1/073, H01R 13/24

(54) **Elektrische Kontaktiervorrichtung sowie elektrisches Kontaktierverfahren**

(30) Priorität: 07.02.2006 DE 102006005522
(71) Anmelder: Feinmetall GmbH, 71083 Herrenberg (DE)
(72) Erfinder: Schmid, Rainer, 72124 Pliezhausen (DE)
(74) Vertreter: Grosse, Rainer

(57) **Zusammenfassung**

Die Erfindung betrifft eine elektrische Kontaktiervorrichtung (1) zum Prüfen von elektrischen Prüflingen (2), mit mindestens einem nach dem Knickdrahtprinzip arbeitenden Kontaktelement (15), das in mindestens einem Führungsloch (10,11,12) axial verschieblich und drehbar geführt ist. Es ist vorgesehen, dass das Kontaktelement (15) einen Offset (O) in Form einer seitlichen, in mindestens eine erste Richtung (19) weisenden Auslenkung (18) aufweist und dass das Führungsloch (10,11,12) mindestens einen in mindestens eine seitliche, zweite Richtung (20) weisenden Führungsabschnitt (13) für das Kontaktelement (15) aufweist, wobei die erste Richtung (19) mit der zweiten Richtung (20) einen Winkel (α) ungleich Null einschließt. Ferner betrifft die Erfindung ein entsprechendes Verfahren.

## Beschreibung

Die Erfindung betrifft eine elektrische Kontaktiervorrichtung zum Prüfen von elektrischen Prüflingen, mit mindestens einem nach dem Knickdrahtprinzip arbeitenden Kontaktelement, das in mindestens einem Führungsloch axial verschieblich und drehbar geführt ist.

Eine Kontaktiervorrichtung der eingangs genannten Art ist bekannt. Sie weist zwei axial beabstandet zueinander liegende Führungsplatten auf, die mit Führungslöchern versehen sind, in denen sich eigenelastische Kontaktelemente in Form von Knickdrähten befinden. Für die elektrische Prüfung eines Prüflings werden die Kontaktenden der Kontaktelemente auf Kontaktstellen des Prüflings gedrückt, wodurch Prüfstrompfade gebildet werden. Durch das Andrücken der Kontaktelemente an den Prüfling federn diese seitlich aus, sodass einerseits jeweils eine Kontaktkraft aufgebracht wird und andererseits auch Höhendifferenzen ausgeglichen werden können. Die Kontaktelemente sind an ihren dem Prüfling abgewandten Enden mit einer elektrischen Prüfeinrichtung verbunden. Sofern die Kontaktstellen zum Prüfling Verunreinigungen aufweisen, beispielsweise durch Oxidschichtbildung, ist der jeweilige Kontaktwiderstand gegebenenfalls nicht optimal.

Der Erfindung liegt daher die Aufgabe zugrunde, eine elektrische Kontaktiervorrichtung der eingangs genannten Art zu schaffen, die bei einfacher Ausbildung stets einen sehr guten elektrischen Kontakt zum Prüfling gewährleistet.

Diese Aufgabe wird erfindungsgemäß dadurch gelöst, dass das Kontaktelement einen Offset in Form einer seitlichen, in mindestens eine erste Richtung weisenden Auslenkung aufweist und dass das Führungsloch mindestens einen in mindestens eine seitliche, zweite Richtung weisenden Führungsabschnitt für das Kontaktelement aufweist, wobei die erste Richtung mit der zweiten Richtung einen Winkel ungleich Null einschließt. Durch die seitliche Auslenkung des Kontaktelements in die erste Richtung und durch die beim Kontaktieren des Prüflings erfolgende Verlagerung der Auslenkung in die zweite Richtung wird auf das Kontaktelement ein Drehmoment ausgeübt, mit der Folge, dass es sich um einen bestimmten Winkelbetrag um seine Längsachse dreht. Durch die selbst initiierte Drehbewegung des Kontaktelements wird der Kontaktwiderstand zum Prüfling verringert und somit stets ein guter Kontakt zum Prüfling hergestellt. Es liegt quasi eine Arbeitsweise nach dem Kurbelprinzip vor, das heißt, das Verlagern der Auslenkung des Kontaktelements in eine Richtung, die nicht der Auslenkrichtung entspricht, sondern quer dazu erfolgt, wird das Kontaktelement "gemäß einer Kurbel" verdreht, wodurch eine optimale elektrische Kontaktierung zum Prüfling erfolgt. Insbesondere feine Strukturen, speziell die Prüfung von Halbleiterbausteinen (Mikrochips) auf Wavern, lassen sich mittels der erfindungsgemäßen elektrischen Kontaktiervorrichtung einfach und sicher bei sehr guten elektrischem Kontakt prüfen.

Die Erfindung betrifft ferner eine elektrische Kontaktiervorrichtung zum Prüfen von elektrischen Prüflingen, mit mindestens einem nach dem Knickdrahtprinzip arbeitenden Kontaktelement, das in mindestens einem Führungselement axial verschieblich und drehbar geführt wird, wobei das Kontaktelement einen Offset in Form einer seitlichen, in mindestens eine erste Richtung weisenden Auslenkung aufweist und das Führungselement in mindestens eine seitliche, zweite Richtung verlagerbar ist, wobei die erste Richtung mit der zweiten Richtung einen Winkel ungleich Null einschließt. Durch die Verlagerung des Führungselements in eine Richtung, die nicht der Richtung der Auslenkung, also der Bogenform, des Kontaktelements entspricht, wird quasi eine "Kurbelkraft" auf das Kontaktelement zu seiner Verdrehung ausgeübt. Dadurch, dass das Kontaktelement für die Kontaktierung des Prüflings axial beaufschlagt wird, übt es im Bereich seiner Auslenkung eine Kraft auf das Führungselement aus, wodurch das Führungselement in die zweite Richtung verlagert wird. Auch hier erfolgt demzufolge eine durch das Kontaktelement selbst initiierte Drehbewegung zur Verbesserung der Kontakteigenschaften zum Prüfling. Das Kontaktelement ist im Führungselement - wie bereits erwähnt - axial verschieblich und drehbar geführt. Insbesondere weist das stiftförmige Kontaktelement einen kreisförmigen Querschnitt auf und die Führung im Kontaktelement erfolgt mittels eines im Querschnitt kreisförmigen Führungsloches, wobei zwischen Führungsloch und Kontaktelement nur ein relativ geringes Bewegungsspiel besteht.

Nach einer Weiterbildung der Erfindung ist vorgesehen, dass das Führungselement mittels mindestens eines lochartigen Führungsabschnitts seitlich verlagerbar ist. Das Führungselement, beispielsweise eine Führungsplatte, weist bevorzugt mindestens einen lochartigen Führungsabschnitt auf, der von einem stationären Führungsmittel, beispielsweise ein Führungsstift, durchsetzt wird. Übt das Kontaktelement durch die Kontaktierung des Prüflings eine Seitenkraft auf das Führungselement aus, so wird sich das Führungselement aufgrund der erwähnten Führungsabschnitt/Führungsstift-Lagerung entsprechend seitlich verschieben und hierbei das Kontaktelement (kurbelartig) mitnehmen und somit die gewünschte Drehbewegung auslösen.

Nach einer Weiterbildung der Erfindung ist vorgesehen, dass der Führungsabschnitt geradlinig oder nicht geradlinig verläuft. Es kann vorgesehen sein, dass der Führungsabschnitt bogenförmig verläuft. Ferner ist es möglich, den Führungsabschnitt winkelförmig verlaufen zu lassen. Selbstverständlich sind auch Mischformen denkbar. Demzufolge kann ein Führungsabschnitt beispielsweise einen geradlinigen Teil und einen sich daran anschließenden bogenförmigen oder winkelförmigen Teil aufweisen. Auch andere Kombinationen sind denkbar.

Nach einer Weiterbildung der Erfindung ist vorgesehen, dass der Offset des Kontaktelements durch Eigenstruktur, insbesondere eine Eigenbiegung, des Kontaktelements gegeben ist. Ist demzufolge das Kontaktelement nicht in den Prüfkopf eingesetzt, so weist dieses bereits auch im unbeaufschlagten Zustand eine seitliche Auslenkung, also einen Offset, auf. Es liegt demzufolge eine Eigenbiegung des Kontaktelements vor. Das Kontaktelement selbst ist ferner stets eigenelastisch, um die Kontaktfederkraft aufzubringen.

Zusätzlich oder alternativ kann vorgesehen sein, dass der Offset des Kontaktelements durch äußere Krafteinwirkung, insbesondere äußere Seitenkrafteinwirkung und/oder Axialkrafteinwirkung, auf das Kontaktelement bewirkt ist. Eine äußere Seitenkrafteinwirkung führt zur Auslenkung des elastischen Kontaktelements und führt demzufolge zum Offset. Zusätzlich oder alternativ kann jedoch auch vorgesehen sein, dass durch eine Axialkrafteinwirkung, wie sie insbesondere bei der Kontaktierung mit dem Prüfling auftritt, das elastische Kontaktelement seitlich ausgelenkt wird und hierdurch seine seitliche Auslenkung erhält, die den Offset bildet. Der Offset kann auch dadurch bewirkt werden, dass das Kontaktelement in mindestens zwei mit Abstand zueinander liegenden Führungslöchern geführt wird, die eine nicht fluchtende Lage aufweisen, also versetzt zueinander liegen. Hierdurch wird das Kontaktelement entsprechend gebogen.

Nach einer Weiterbildung der Erfindung ist vorgesehen, dass das dem Prüfling abgewandte Ende des Kontaktelements axial unverschieblich, jedoch drehbar gelagert ist. Die Axialkraft durch die Prüflingskontaktierung wird demzufolge von der axial unverschieblichen Lagerung am Ende des Kontaktelements aufgenommen, wobei jedoch die Drehbarkeit des Kontaktelements erhalten bleiben muss, um eine Verdrehung der Kontaktspitze zur Verminderung des Kontaktwiderstandes zum Prüfling bewirken zu können.

Die Erfindung betrifft ferner ein elektrisches Kontaktierverfahren zum Prüfen von elektrischen Prüflingen, insbesondere zur Anwendung bei der vorstehend beschriebenen Kontaktiervorrichtung, mit mindestens einem nach dem Knickdrahtprinzip arbeitenden Kontaktelement, dass axialverschieblich und drehbar gelagert ist, wobei das Kontaktelement einen Offset in Form einer seitlichen, in mindestens eine erste Richtung weisenden Auslenkung aufweist und im Bereich dieser Auslenkung durch die Kontaktierung des Prüflings derart geführt wird, dass eine Verlagerung der Auslenkung in eine zweite Richtung erfolgt, die mit der ersten Richtung einen Winkel ungleich Null einschließt.

Die Zeichnungen veranschaulichen die Erfindung anhand von Ausführungsbeispielen, und zwar zeigt:
- Figur 1: eine elektrische Kontaktiervorrichtung in einem einen Prüfling nicht kontaktierenden Zustand,
- Figur 2: die Anordnung der Figur 1 in einem den Prüfling kontaktierenden Zustand,
- Figuren 3 bis 5: verschiedene Ausführungsformen von Führungsabschnitten für Kontaktelemente der elektrischen Kontaktiervorrichtung,
- Figur 6: ein Führungselement einer weiteren Ausführungsform der elektrischen Kontaktiervorrichtung und
- Figur 7: ein Prinzipbild zur Erläuterung des erfindungsgemäßen Grundprinzips.

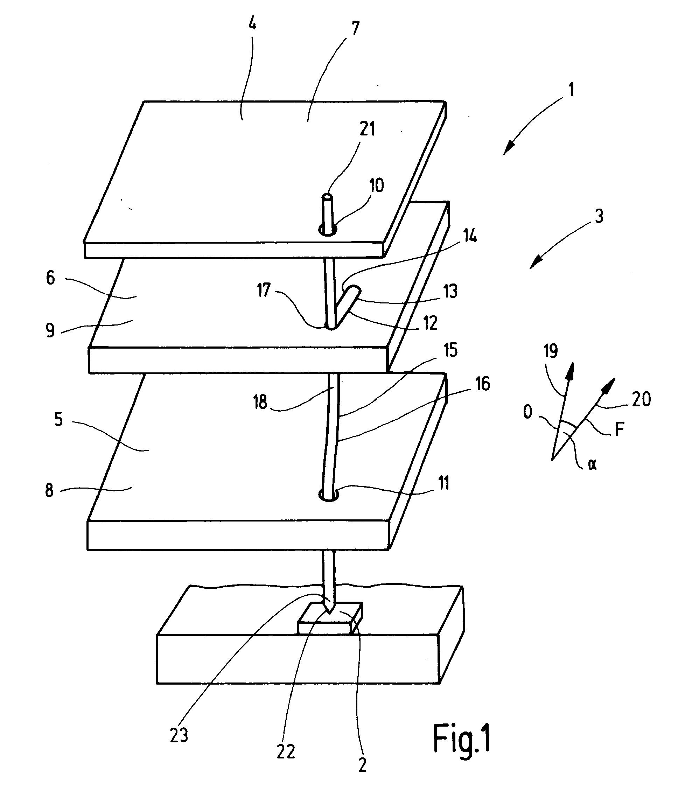

Die Figur 1 zeigt eine perspektivische Ansicht einer schematisch dargestellten elektrischen Kontaktiervorrichtung 1 zum Prüfen eines elektrischen Prüflings 2. Die elektrische Kontaktiervorrichtung 1 weist einen Prüfkopf 3 auf, der ein erstes Führungselement 4 und ein zweites Führungselement 5 besitzt. Zwischen dem ersten und dem zweiten Führungselement 4, 5 ist ein drittes Führungselement 6 des Prüfkopfs 3 angeordnet. Die Führungselemente 4 bis 6 sind jeweils als Führungsplatten 7 bis 9 ausgebildet. Die Führungsplatten 7 bis 9 verlaufen parallel mit axialem Abstand zueinander.

Die Führungsplatte 7 weist ein kreisförmiges Führungsloch 10 und die Führungsplatte 8 ein kreisförmiges Führungsloch 11 auf. Die Führungsplatte 9 besitzt ein Führungsloch 12, das einen Führungsabschnitt 13 besitzt, das heißt, es liegt keine kreisförmige Lochform vor, sondern - im Ausführungsbeispiel der Figur 1 - eine langlochförmige Form. Demgemäß bilden Führungsloch 12 mit Führungsabschnitt 13 ein Langloch 14. Die beiden Führungslöcher 10 und 11 und das Langloch 14 werden von einem Kontaktelement 15 durchsetzt, das einen kreisförmigen Querschnitt besitzt und aufgrund von Eigenelastizität einen Knickdraht 16 bildet. Im nicht in die Führungsplatten 7 bis 9 eingesetzten Zustand weist das Kontaktelement 15 hinsichtlich seiner Längserstreckung einen geradlinigen Verlauf auf.

Die beiden Führungslöcher 10 und 11 fluchten miteinander. Der Endbereich 17 des Langlochs 14 fluchtet nicht mit den beiden Führungslöchern 10 und 11, mit der Folge, dass der eingesteckte Knickdraht 16 eine seitliche Auslenkung 18 erhält gegenüber seiner geradlinigen Form, also einen Offset O aufweist. Die Richtung des Offsets O ist als Pfeil in Figur 1 dargestellt. Die Pfeilrichtung verkörpert die Richtung der seitlichen Auslenkung 18; sie weist in eine erste Richtung 19. Die Längserstreckung des Langlochs 14 weist in eine zweite Richtung 20, das heißt, der Führungsabschnitt 13 weist in die Richtung 20, die in der Figur mit F gekennzeichnet ist.

Der Figur 1 ist zu entnehmen, dass die erste Richtung 19 mit der zweiten Richtung 20 einen Winkel α einschließt, der ungleich Null ist. Im vorliegenden Falle handelt es sich um einen spitzen Winkel.

Das dem Prüfling 2 abgewandte Ende 21 des Kontaktelements 15 stützt sich an einem elektrischen Gegenkontakt ab, der zu einer Prüfeinrichtung führt. Gegenkontakt und Prüfeinrichtung sind der Einfachheit halber nicht dargestellt. Die Figur 1 zeigt lediglich ein einziges Kontaktelement 15 des Prüfkopfes 3. Da es sich bei dem Prüfling 2 beispielsweise um einen Halbleiterbaustein auf einem Waver handeln kann, der zur Prüfung mit einer Vielzahl von Prüfströmen beaufschlagt werden muss, weist der Prüfkopf in der Praxis eine Vielzahl von Kontaktelementen 15 auf, die alle gleichzeitig mit dem Prüfling in Kontakt gebracht werden. Hierzu wird der Prüfling 2 relativ zum Prüfkopf 3 derart bewegt, dass das vorzugsweise mit Kontaktspitze 22 versehene Ende 23 jedes Kontaktelements 15 auf den Prüfling 2 aufsetzt, wodurch eine axiale Kraft auf das jeweilige Kontaktelement 15 ausgeübt wird mit der Folge, dass dieses sich nach dem Knickdrahtprinzip seitlich ausbiegt. Eine axiale Verlagerung des Endes 21 des Kontaktelements 15 ist durch eine Abstützung an dem erwähnten Gegenstand gegen Kontakt verhindert. Allerdings liegt das Ende 21 nur gegen den Gegenkontakt an, das heißt, eine Drehbewegung des Kontaktelements 15, auf die nachstehend näher eingegangen wird, ist durchführbar.

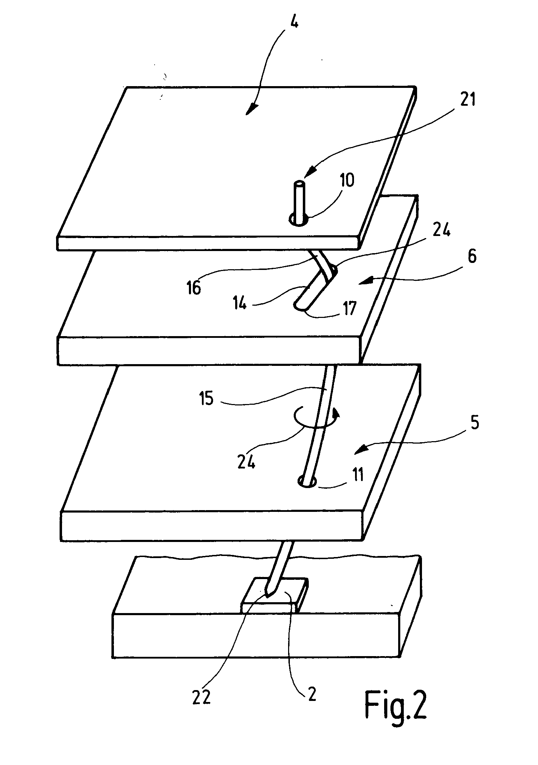

Wird das Kontaktelement 15 durch die Kontaktierung mit dem Prüfling seitlich ausgelenkt, so erfolgt dies in eine Richtung, die von der Richtung des Offsets O (erste Richtung 19) abweicht, da die Ausknickrichtung durch den Verlauf des Langlochs 14 vorgegeben wird, das in die zweite Richtung 20 weist. Demzufolge wird sich - wie ein Vergleich der Figuren 1 und 2 zeigt - bei der Kontaktierung eine Verlagerung der Auslenkung 18 innerhalb des Langlochs 14 vom Endbereich 17 in den Endbereich 24 ergeben. Da der Offset O in seiner ersten Richtung 19 von dem Verlauf des Langlochs F (zweite Richtung 20) abweicht, was durch den Winkel α repräsentiert wird, ergibt sich durch die Kontaktierungsbewegung eine Verdrehung 24 des Kontaktelements 15 um einen bestimmten Winkelbetrag, mit der Folge, dass diese Drehbewegung auch von der an den Prüfling 2 angedrückten Kontaktspitze 22 durchgeführt wird. Diese Drehbewegung führt zu einem sehr guten elektrischen Kontakt, da beispielsweise Oxidschichten hierdurch durchdrungen werden.

Wird der Prüfling 2 wieder vom Prüfkopf 3 entfernt, so federt das Kontaktelement 15 in die aus der Figur 1 hervorgehenden Stellung zurück, wobei eine Rückdrehung erfolgt.

Aus vorstehenden Erläuterungen wird deutlich, dass das Kontaktelement 15 aufgrund des Versatzes der Führungslöcher 10 bis 12 eine Auslenkung 18 in Form eines Offsets O aufweist. Grundsätzlich ist es auch möglich, dass dieser Offset O durch eine Eigenbiegung/Eigenkrümmung, also durch eine Eigenstruktur des Kontaktelements selbst, vorliegt, das heißt, ein nicht belastetes, also nicht in den Prüfkopf 3 eingesetztes Kontaktelement 15 weist von sich aus einen von der geradlinigen Form abweichenden Verlauf, beispielsweise eine Bogenform, auf. Der Offset O kann zusätzlich oder alternativ auch dadurch gebildet sein, dass eine äußere Krafteinwirkung seitlich auf das Kontaktelement 15 erfolgt, so wie dies aufgrund der nicht fluchtenden Lage der Führungslöcher 10 bis 12 im Ausführungsbeispiel der Figur 1 beispielsweise erfolgt. Es sind jedoch auch andere Krafteinwirkungen denkbar, die eine entsprechende Auslenkung 18 herbeiführen können. Zusätzlich oder alternativ ist es auch möglich, dass die Auslenkung erst dadurch entsteht, dass mit dem Kontaktelement 15 eine Kontaktierung des Prüflings 2 herbeigeführt wird, dass also das Auslenken aufgrund des Knickdrahtprinzips erfolgt (Auslenken durch Aufsetzen auf den Prüfling). Um dann eine Drehbewegung bei der Kontaktierung herbeiführen zu können, ist es erforderlich, das Kontaktelement 15 in einem Führungsabschnitt 13 zu führen, der nicht in Richtung der Auslenkung 18 weist, sondern von dieser Richtung abweicht. Dies kann beispielsweise dadurch erzielt werden, dass das Langloch kein geradliniges Langloch, sondern beispielsweise ein bogenförmiges Langloch ist.

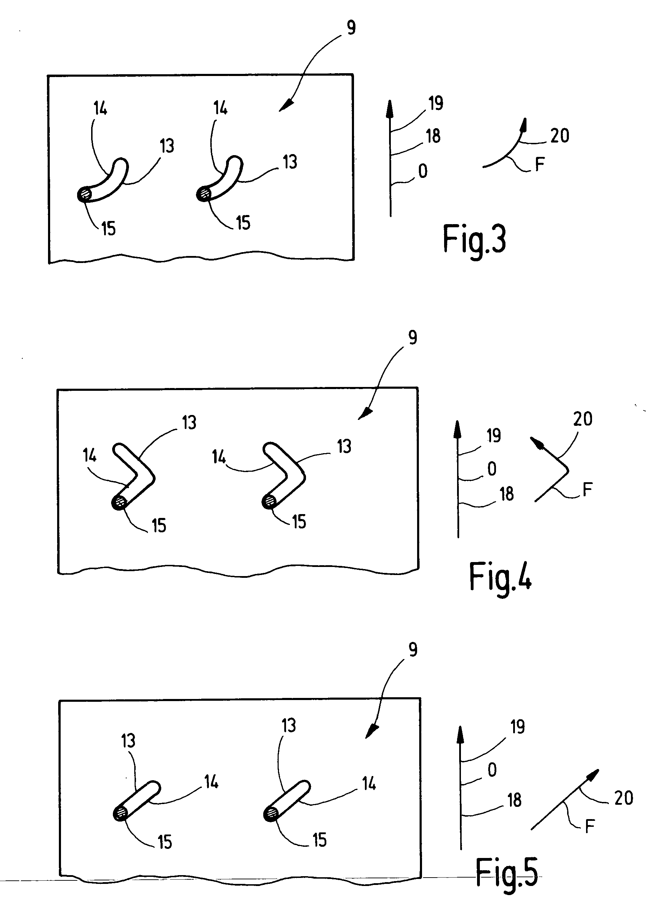

Aus den Figuren 3 bis 5 gehen verschiedenartig ausgebildete Führungsabschnitte 13 in Form von Langlöchern 14 hervor, die - unabhängig davon, ob die Auslenkung 18 durch Eigenkrümmung oder äußere Krafteinwirkung erzeugt ist - bogenförmig, insbesondere bananenförmig, oder dergleichen ausgebildet sind.

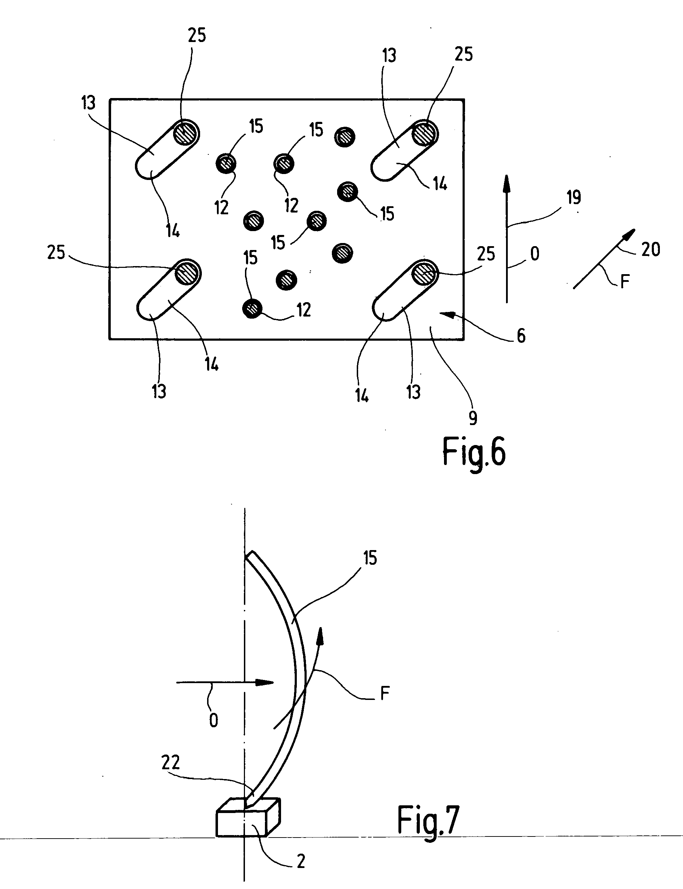

Die Figuren 4 und 5 zeigen weitere, nicht geradlinig verlaufende Langlöcher 14, das heißt in der Figur 4 ist der jeweilige Führungsabschnitt 13 winkelförmig und in der Figur 5 - zur Verdeutlichung des Ausführungsbeispiels der Figur 1 - nochmals geradlinig ausgebildet. Ferner ist in den Figuren 3 bis 5 jeweils die Auslenkung 18 in Form des Offsets O eingetragen, die eine erste Richtung 19 aufweist. Ferner ist die Führung F aufgrund der Formgebung des jeweiligen Langlochs 14 eingetragen, was zu einer zweiten Richtung 20 führt. Es ist erkennbar, dass die erste Richtung 19 zur zweiten Richtung 20 stets einen Winkel α einschließt, der von Null abweicht. Bei gekrümmten Langlochverläufen ändert sich die zweite Richtung 20 während der Verlagerung des Kontaktelements 15.

Die Figur 6 verkörpert ein weiteres Ausführungsbeispiel einer erfindungsgemäßen Kontaktiervorrichtung 1, von der lediglich das Führungselement 6, also die Führungsplatte 9, dargestellt ist. Ansonsten entspricht die Ausbildung der Kontaktiervorrichtung 1 gemäß Figur 6 der der Figur 1, sodass auf die dortigen Ausführungen verwiesen wird. Anders als beim Ausführungsbeispiel der Figur 1 ist nicht das Kontaktelement 15 in einem Langloch 14 verlagerbar, sondern die jeweiligen Kontaktelemente 15 durchsetzen mit nur geringem Spiel Führungslöcher 12 in der Führungsplatte 9, sind dort also längsverschieblich sowie drehbar gelagert. Um nun die erwähnte zweite Richtung 20 bei einer Kontaktierung des Prüflings 3 zu realisieren, ist das gesamte Führungselement 6 seitlich verlagerbar, indem es insbesondere mehrere Führungsabschnitte 13 in Form von Langlöchern 14 aufweist, wobei die Langlöcher 14 identisch ausgebildet und in ihrer Längserstreckung gleichgerichtet angeordnet sind. Die Langlöcher 14 werden von prüfkopffesten Führungsstangen 25 mit geringem Spiel durchsetzt. In Figur 6 sind geradlinige Langlöcher 14 dargestellt; es ist jedoch auch möglich, dass von der geradlinigen Form abgewichen wird, beispielsweise bogen- oder winkelförmige Formen vorhanden sind.

Wird nun beim Ausführungsbeispiel der Figur 6 eine Kontaktierung des Prüflings 2 vorgenommen, so üben die jeweils einen Offset O aufweisenden Kontaktelemente 15 bei der Kontaktierung jeweils eine Kraft auf das Führungselement 6 aus, sodass dieses seitlich ausgelenkt wird, wobei die Auslenkrichtung durch den Verlauf der Langlöcher 14 bestimmt wird. Da auch hier wieder Offset (erste Richtung 19) und die entsprechende Führung F aufgrund der Langlöcher 14 (zweite Richtung 20) einen Winkel zueinander einschließen, der ungleich Null ist, ergibt sich eine Drehbewegung jedes Kontaktelements 15 mit der Folge einer entsprechend guten elektrischen Kontaktierung des Prüflings 2.

In Figur 7 ist das erfindungsgemäße Prinzip nochmals verdeutlicht. Gezeigt ist ein mit Offset O versehenes Kontaktelement 15, das einen Prüfling 2 anfänglich kontaktiert. Wird nun - zum Aufbau des vollen Kontaktdrucks- der Prüfling 2 noch stärker an das Kontaktelement 15 angedrückt, so wird aufgrund der erläuterten Stiftführung (F) auf den ausgelenkten Bereich eine Kraft ausgeübt, deren Richtung von der Richtung des Offsets abweicht, mit der Folge, dass der ausgelenkte Bereich quasi wie eine Kurbel bewegt wird, was zu einer Drehbewegung der Kontaktspitze 22 auf dem Prüfling 2 führt.

Die Erfindung besteht demgemäß darin, dass die einzelnen Knickdrähte während des Kontaktierens jeweils eine selbst iniziierte Drehbewegung ausführen, um den Kontaktwiderstand zum Prüfling zu verringern beziehungsweise einen sehr guten Kontakt zum Prüfling zu gewährleisten. Vorzugsweise kann zwischen der ersten Richtung 19 und der zweiten Richtung 20 ein Winkel von 45° liegen. Die erfindungsgemäße Drehbewegung/Rollbewegung des im Querschnitt kreisförmigen Kontaktes während der Kontaktierung erfolgt dadurch, dass er eigentlich in Offsetrichtung ausknicken will, jedoch durch die Führung in eine andere Richtung gezwungen wird. Es sind Ausführungsformen denkbar, bei denen die entsprechende Führung bananenförmig, S-förmig, Z-förmig usw. ausgebildet sein kann. Stets muss eine entsprechende Richtungsänderung durchgeführt werden, damit der Kontakt zu rollen beginnt und die Drehbewegung erfolgt. Auch bei dem Ausführungsbeispiel, bei dem die Führung insgesamt verlagert wird (Ausführungsbeispiel der Figur 6) können entsprechend unterschiedliche Ausgestaltungen bei den Langlöchern vorgesehen sein, also bogenförmig, bananenförmig, winkelförmig, S-förmig, Z-förmig usw.. Es ist auch möglich, eine kinematische Umkehr durchzuführen, das heißt, die Langlöcher 14 beim Ausführungsbeispiel der Figur 6 befinden sich am Prüfkopf 3, während die Führungsstangen 25 in fester Position am Führungselement 6 angeordnet sind.

## Patentansprüche

1. Die Erfindung betrifft eine elektrische Kontaktiervorrichtung zum Prüfen von elektrischen Prüflingen, mit mindestens einem nach dem Knickdrahtprinzip arbeitenden Kontaktelement, das in mindestens einem Führungsloch axial verschieblich und drehbar geführt ist, **dadurch gekennzeichnet, dass** das Kontaktelement (15) einen Offset (O) in Form einer seitlichen, in mindestens eine erste Richtung (19) weisenden Auslenkung (18) aufweist und dass das Führungsloch (10,11,12) mindestens einen in mindestens eine seitliche, zweite Richtung (20) weisenden Führungsabschnitt (13) für das Kontaktelement (15) aufweist, wobei die erste Richtung (19) mit der zweiten Richtung (20) einen Winkel (α) ungleich Null einschließt.

2. Elektrische Kontaktiervorrichtung zum Prüfen von elektrischen Prüflingen, mit mindestens einem nach dem Knickdrahtprinzip arbeitenden Kontaktelement, das in mindestens einem Führungselement axial verschieblich und drehbar geführt wird, **dadurch gekennzeichnet, dass** das Kontaktelement (15) einen Offset (O) in Form einer seitlichen, in mindestens eine erste Richtung (19) weisenden Auslenkung (18) aufweist und dass das Führungselement (4,5,6) in mindestens eine seitliche, zweite Richtung (20) verlagerbar ist, wobei die erste Richtung (19) mit der zweiten Richtung (20) einen Winkel (α) ungleich Null einschließt.

3. Elektrische Kontaktiervorrichtung nach einem der vorhergehenden Ansprüche, **dadurch gekennzeichnet, dass** das Führungselement (4,5,6) mittels mindestens eines lochartigen Führungsabschnitts (13) seitlich verlagerbar ist.

4. Elektrische Kontaktiervorrichtung nach einem der vorhergehenden Ansprüche, **dadurch gekennzeichnet, dass** der Führungsabschnitt (13) geradlinig oder nicht geradlinig verläuft.

5. Elektrische Kontaktiervorrichtung nach einem oder mehreren der vorhergehenden Ansprüche, **dadurch gekennzeichnet, dass** der Führungsabschnitt (13) bogenförmig verläuft.

6. Elektrische Kontaktiervorrichtung nach einem oder mehreren der vorhergehenden Ansprüche, **dadurch gekennzeichnet, dass** der Führungsabschnitt (13) winkelförmig verläuft.

7. Elektrische Kontaktiervorrichtung nach einem oder mehreren der vorhergehenden Ansprüche, **dadurch gekennzeichnet, dass** der Offset (O) des Kontaktelements (15) durch eine Eigenstruktur, insbesondere eine Eigenbiegung, des Kontaktelements (15) gegeben ist.

8. Elektrische Kontaktiervorrichtung nach einem oder mehreren der vorhergehenden Ansprüche, **dadurch gekennzeichnet, dass** der Offset (O) des Kontaktelements (15) durch äußere Krafteinwirkung, insbesondere äußere Seitenkrafteinwirkung und/oder Axialkrafteinwirkung, auf das Kontaktelement (15) bewirkt ist.

9. Elektrische Kontaktiervorrichtung nach einem oder mehreren der vorhergehenden Ansprüche, **dadurch gekennzeichnet, dass** der Offset (O) des Kontaktelements (15) durch eine nicht fluchtende Lage mindestens zweier Führungslöcher (10,11,12) bewirkt ist.

10. Elektrische Kontaktiervorrichtung nach einem oder mehreren der vorhergehenden Ansprüche, **dadurch gekennzeichnet, dass** das dem Prüfling (2) abgewandte Ende (21) des Kontaktelements (15) axial unverschieblich, jedoch drehbar gelagert ist.

11. Elektrisches Kontaktierverfahren zum Prüfen von elektrischen Prüflingen, insbesondere zur Anwendung bei einer Vorrichtung nach einem oder mehreren der vorhergehenden Ansprüche, mit mindestens einem nach dem Knickdrahtprinzip arbeitenden Kontaktelement, das axial verschieblich und drehbar gelagert ist, **dadurch gekennzeichnet, dass** das Kontaktelement einen Offset in Form einer seitlichen, in mindestens eine erste Richtung weisenden Auslenkung aufweist und im Bereich dieser Auslenkung durch die Kontaktierung des Prüflings derart geführt wird, dass eine Verlagerung der Auslenkung in eine zweite Richtung erfolgt, die mit der ersten Richtung einen Winkel ungleich Null einschließt.
